# EUROPEAN PATENT APPLICATION

(11) **EP 3 240 271 A1**
(43) Date of publication of application: **01.11.2017**
(21) Application number: 15871664.7
(22) Date of filing: 07.07.2015
(51) Int. Cl.: H04M 1/725, G01R 31/02

(54) **GROUNDING ADJUSTMENT METHOD AND DEVICE**

(30) Priority: 25.12.2014 CN 201410830768
(71) Applicant: ZTE Corporation, Shenzhen, Guangdong 518057 (CN)
(72) Inventor: SHEN, Shaowu, Shenzhen Guangdong 518057 (CN)
(74) Representative: Novagraaf Technologies
(86) International application number: PCT/CN2015/083478
(87) International publication number: WO 2016/101590

(57) **Abstract**

At least some embodiments of disclosure include a method and device for grounding adjustment. The method includes: acquiring a grounding parameter of a port to be detected of a terminal, wherein the grounding parameter is reflective of a grounding state of the port to be detected; when the grounding parameter exceeds a predetermined threshold, determining that the grounding state of the port to be detected does not meet a preset requirement; and adjusting the port to be detected not meeting the preset requirement according to a reason why the grounding state does not meet the preset requirement. According to the method and device for the grounding adjustment, a problem that a grounding state of the terminal cannot be detected or adjusted is solved, and thereby the intelligent grounding detection and calibration optimizing process of the terminal are achieved, and faults such as poor communication quality, high heat and electrostatic discharge caused by the grounding problem are avoided.

## Description

### Technical Field

The disclosure relates to the field of communications, and in particular to a method and device for grounding adjustment.

### Background

Along with a diversity of terminal (for example, mobile phone) usage environments and due to a structure complexity of electronic devices, loose structures of electronic devices caused by falling off or turning over in long-term usage, and an aging, corrosion and deformation of conducting grounding materials cause deterioration in grounding performances; therefore, during a usage of smart mobile terminals, function requirement on the detection and processing of grounding performance becomes very important.

Meanwhile, due to a diversity of radio frequency bands, more and more antennas are arranged in mobile phones; besides Second Generation (2G) or Third Generation (3G) or Fourth Generation (4G) main radio frequency antennas, there are other wireless antennas, such as Wireless Fidelity (WiFi), Bluetooth (BT), Global Position System (GPS), Digital Television (DTV) and Near Field Communication (NFC); due to influence of various interferences, if mobile phone grounding shielding is poor, a transmitting or receiving performance of mobile phones will be greatly influenced, thus the call completion ratio, calling quality and Internet speed of users will be influenced. Therefore, the shielding grounding processing of mobile phones is necessary.

In addition, adjustment processes of mobile phone hardware circuits and antennas are based on certain reference ground plane. There are many grounding modes, such as single point grounding and multipoint grounding; if the reference ground changes, an active efficiency of mobile phone antennas will be changed, thereby antenna performance and signal quality of users are influenced; therefore, a consistency of reference ground planes is very important.

At present, common grounding modes of mobile phones and detection methods of the mobile phones are as follows: 1. through a special grounding measuring instrument, such as detection platform, detection system and detection device; 2. monitoring of power transmission line grounding in an electric system; 3. detecting a grounding device through a multi-meter; 4. fixing grounding of conductive foam or conductive fabric, copper foil, etc.; 5. grounding of mobile shrapnel or clamp; 6. direct single-point or multi-point grounding through a grounding line; 7. directly punching to the ground via a small hole or big hole.

For the Method 1, the usage of a special grounding detection device has a large system and is inconvenient to carry. For the Method 2, generally, the grounding in a special electric system is different from the grounding in a micro-electronic terminal device. For the Method 3, the detection realized through the resistance detection by the measurement of a traditional multi-meter is complex and the usage condition has limitation. For the method 4: the grounding material such as conductive foam or conductive fabric, etc. has poor stability and is easy to deform. For the Method 5, the grounding material such as metal shrapnel or clamp has big volume and the usage condition is strict. For the Method 6 and the Method 7, the grounding mode is single and is unchangeable, whether the grounding performance is suitable is unknown.

In view of a problem that a grounding state of a terminal cannot be detected or adjusted, no solution has been proposed so far.

### Summary

At least some embodiments of the disclosure include a method and device for grounding adjustment, so as to at least partially solve a problem that a grounding state of a terminal cannot be detected or adjusted.

In an embodiment of the disclosure, a method for grounding adjustment is provided, which includes that: acquiring a grounding parameter of a port to be detected of a terminal, wherein the grounding parameter is reflective of a grounding state of the port to be detected; when the grounding parameter exceeds a predetermined threshold, determining that the grounding state of the port to be detected does not meet a preset requirement; and adjusting the port to be detected not meeting the preset requirement according to a reason why the grounding state does not meet the preset requirement.

In one embodiment, acquiring the grounding parameter of the port to be detected includes: receiving a detection instruction on a User Interface (UI); and under a trigger of the detection instruction, acquiring the grounding parameter and displaying the grounding parameter on the UI.

In one embodiment, acquiring the grounding parameter of the port to be detected includes: detecting a grounding circuit of the port to be detected; and acquiring the grounding parameter according to a detection result.

In one embodiment, before detecting the grounding circuit of the port to be detected, the method further includes: determining that the terminal has a port not meeting the preset requirement by detecting information about at least one of the following of the terminal: a signal strength of the terminal does not fall in a range of a first threshold, a signal frequency of the terminal does not fall in a range of a second threshold, a temperature of the terminal does not fall in a range of a third threshold.

In one embodiment, the reason why the grounding state does not meet the preset requirement is determined by the following ways: determining the reason why the grounding state does not meet the preset requirement according to a position of the port to be detected in the terminal and a grounding mode of the port to be detected.

In one embodiment, adjusting the port to be detected not meeting the preset requirement according to the reason why the grounding state does not meet the preset requirement includes at least one of the following: adjusting at least one of a grounding position and a grounding attribute of at least one of the port to be detected and a nearby port of the port to be detected; adjusting a grounding position of the port to be detected and increasing a number of grounded ports on a shield circuit; adjusting a grounding mode of the port to be detected; and adjusting at least one of an antenna grounding feed point of the terminal and an antenna surrounding grounding circuit of the terminal.

In one embodiment, a grounding mode includes at least one of the following: analogue grounding, digital grounding, single point grounding, multipoint grounding, small-hole grounding, large-hole grounding, main reference grounding, non-main reference grounding.

In one embodiment, the grounding parameter includes at least one of the following: grounding resistance, grounding current, grounding voltage.

In another embodiment of the disclosure, a device for grounding adjustment is provided, including: an acquisition component to acquire a grounding parameter of a port to be detected of a terminal, wherein the grounding parameter is reflective of a grounding state of the port to be detected; a first determination component to determine that the grounding state of the port to be detected does not meet a preset requirement in the case that the grounding parameter exceeds a predetermined threshold; and an adjustment component to adjust the port to be detected not meeting the preset requirement according to a reason why the grounding state does not meet the preset requirement.

In one embodiment, the acquisition component includes: a first detection element to receive a detection instruction on a User Interface (UI); and a first acquisition element to acquire the grounding parameter and display the grounding parameter on the UI under a trigger of the detection instruction.

In one embodiment, the acquisition component further includes: a second detection element to detect a grounding circuit of the port to be detected; and a second acquisition element to acquire the grounding parameter according to a detection result.

In one embodiment, the device includes: a second determination component to determine that the terminal has a port not meeting the preset requirement by detecting information about at least one of the following of the terminal: a signal strength of the terminal does not fall in a range of a first threshold, a signal frequency of the terminal does not fall in a range of a second threshold, a temperature of the terminal does not fall in a range of a third threshold.

In one embodiment, the first determination component is further to determine the reason why the grounding state does not meet the preset requirement according to a position of the port to be detected in the terminal and a grounding mode of the port to be detected.

In one embodiment, the adjustment component includes at least one of the following: a first adjustment element to adjust at least one of a grounding position and a grounding attribute of at least one of the port to be detected and a nearby port of the port to be detected; a second adjustment element to adjust the grounding position of the port to be detected and increase the number of grounded ports on a shield circuit; a third adjustment element to adjust a grounding mode of the port to be detected; and a fourth adjustment element to adjust at least one of an antenna grounding feed point of the terminal and an antenna surrounding grounding circuit of the terminal.

In one embodiment, a grounding mode includes at least one of the following: analogue grounding, digital grounding, single point grounding, multipoint grounding, small-hole grounding, large-hole grounding, main reference grounding, non-main reference grounding.

In one embodiment, the grounding parameter includes at least one of the following: grounding resistance, grounding current, grounding voltage.

Through at least some embodiments of the disclosure, a grounding parameter of a port to be detected of a terminal is acquired, in which the grounding parameter is used for reflecting the grounding state of the port to be detected; when the grounding parameter exceeds a predetermined threshold, it is determined that the grounding state of the port to be detected does not meet a preset requirement; and the port to be detected not meeting the preset requirement is adjusted according to the reason why the grounding state does not meet the preset requirement. The problem that the grounding state of the terminal cannot be detected or adjusted is solved, and thereby the intelligent grounding detection and calibration optimizing process of the terminal are achieved, and faults such as poor communication quality, high heat and electrostatic discharge caused by the grounding problem are avoided.

### Brief Description of the Drawings

For a better understanding of the disclosure, accompanying drawings described hereinafter are provided to constitute one part of the application; the schematic embodiments of the disclosure and the description thereof are used to illustrate the disclosure but to limit the disclosure improperly. In the accompanying drawings:
Fig. 1 is a flowchart of a method for grounding adjustment according to an embodiment of the disclosure.
Fig. 2 is a structural block diagram of a device for grounding adjustment according to an embodiment of the disclosure.
Fig. 3 is a structural block diagram of a device for grounding adjustment according to a first example embodiment of the disclosure.
Fig. 4 is a structural block diagram of a device for grounding adjustment according to a second example embodiment of the disclosure.
Fig. 5 is a structural block diagram of a device for grounding adjustment according to a third example embodiment of the disclosure.
Fig. 6 is a structural block diagram of a device for grounding adjustment according to a fourth example embodiment of the disclosure.
Fig. 7 is a diagram of a hardware structure realizing an intelligent grounding terminal according to an embodiment of the disclosure.
Fig. 8 is a specific working flowchart of an adaptive grounding adjustment terminal according to an embodiment of the disclosure.

### Detailed Description

The disclosure is described below in detail by reference to the accompanying drawings in conjunction with embodiments. It should be noted that the embodiments in the application and the characteristics of the embodiments can be combined if no conflict is caused.

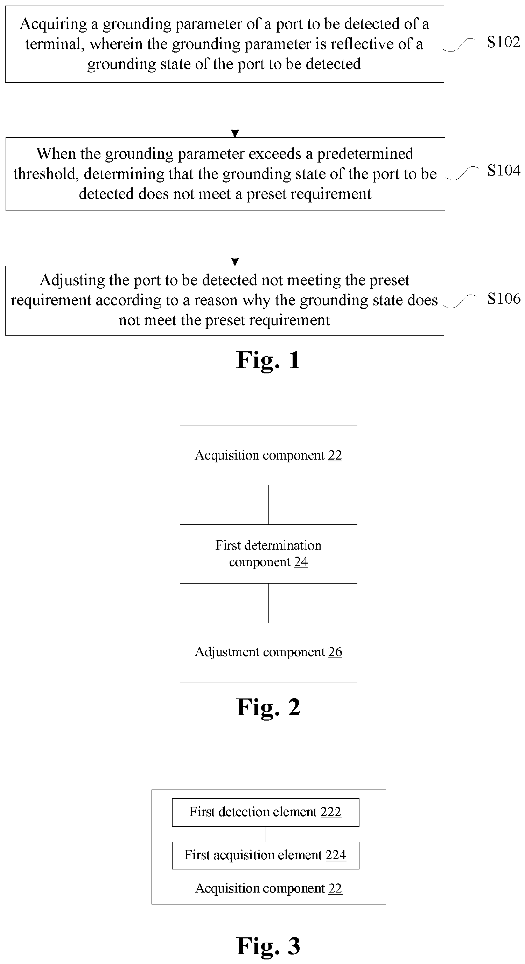

A method for grounding adjustment is provided in this embodiment; Fig. 1 is a flowchart of a method for grounding adjustment according to an embodiment of the disclosure; as shown in Fig. 1, the process includes the following steps:
At step S102: A grounding parameter of a port to be detected of a terminal is acquired, in which the grounding parameter is reflective of a grounding state of the port to be detected.
At step S104: When the grounding parameter exceeds a predetermined threshold, it is determined that the grounding state of the port to be detected does not meet a preset requirement.
At step S106: The port to be detected not meeting the preset requirement is adjusted according to a reason why the grounding state does not meet the preset requirement.

Through the above steps, it is determined according to the grounding parameter of the terminal port whether the grounding condition of the port is abnormal, in which, when the grounding parameter exceeds a predetermined threshold, it is determined that the grounding state of the port does not meet a preset requirement, so that the port not meeting the preset requirement can be adjusted, the problem that the grounding state of the terminal cannot be detected or adjusted is solved, and thereby the intelligent grounding detection and calibration optimizing process of the terminal are achieved, and faults such as poor communication quality, high heat and electrostatic discharge caused by the grounding problem are avoided.

The above step S102 involves acquiring the grounding parameter of the port to be detected; in an optional embodiment, a detection instruction is received on a UI; and, under a trigger of the detection instruction, the grounding parameter is acquired and the grounding parameter is displayed on the UI. A UI detection window displays each grounding position and architecture graphically and modularly in a distributed manner, realizing a subwindow-user interactive display interface; a user can activate a monitor port by touching the UI to view specific parameters and adjustment methods.

The above step S102 involves acquiring a grounding parameter of a port to be detected; it should be noted that the grounding parameter of the port can be acquired by many ways; examples are taken below for description. In an optional embodiment, a grounding circuit of the port to be detected is detected; and the grounding parameter of the port to be detected is acquired through the grounding circuit of the port to be detected.

Before the grounding circuit of the port to be detected is detected, in an optional embodiment, it is determined that the terminal has a port not meeting the preset requirement by detecting that a signal strength of the terminal does not fall in a range of a first threshold, a signal frequency of the terminal does not fall in a range of a second threshold, or a temperature of the terminal does not fall in a range of a third threshold.

In an optional embodiment, the reason why the grounding state does not meet the preset requirement is determined according to a position of the port to be detected in the terminal and the grounding mode of the port to be detected. There may be many reasons why the grounding state of the port to be detected does not meet the preset requirement; the reason is not limited to the above.

The above step S106 involves adjusting the port to be detected not meeting the preset requirement according to the reason why the grounding state does not meet the preset requirement; in an optional embodiment, at least one of a grounding position and a grounding attribute of at least one of the port to be detected and a nearby port of the port to be detected may be adjusted; in another optional embodiment, a grounding position of the port to be detected may be adjusted and a number of grounded ports on a shielding rib may be increased; in another optional embodiment, a grounding mode of the port to be detected may be adjusted; and in another optional embodiment, at least one of an antenna grounding feed point of the terminal and an antenna surrounding grounding circuit of the terminal may be further adjusted, in which the antenna surrounding grounding circuit may be a grounding circuit in a surrounding of an antenna area, or a relevant grounding circuit, ground connector or grounding material influencing antenna performance.

In an optional embodiment, a grounding mode includes at least one of the following: analogue grounding, digital grounding, single point grounding, multipoint grounding, small-hole grounding, large-hole grounding, main reference grounding, non-main reference grounding.

In an optional embodiment, the grounding parameter includes at least one of the following: grounding resistance, grounding current, grounding voltage.

A device for grounding adjustment is further provided in this embodiment; the device is arranged to implement the above embodiments and example implementations, what has been described above is not repeated below. Term "component" used below can realize the combination of at least one of software and hardware with preset functions. Although the device described in the following embodiments is implemented in the form of software, the implementation in the form of hardware or the combination of software and hardware is possible and conceived.

Fig. 2 is a structural block diagram of a device for grounding adjustment according to an embodiment of the disclosure. As shown in Fig. 2, the device includes: an acquisition component 22 to acquire a grounding parameter of a port to be detected of a terminal, wherein the grounding parameter is reflective of a grounding state of the port to be detected; a first determination component 24 to determine that the grounding state of the port to be detected does not meet a preset requirement in the case that the grounding parameter exceeds a predetermined threshold; and an adjustment component 26 to adjust the port to be detected not meeting the preset requirement according to a reason why the grounding state does not meet the preset requirement.

Fig. 3 is a structural block diagram of a device for grounding adjustment according to a first embodiment of the disclosure; as shown in Fig. 3, the acquisition component 22 includes: a first detection element 222 to receive a detection instruction on a UI; and a first acquisition element 224 to acquire the grounding parameter and display the grounding parameter on the UI under a trigger of the detection instruction.

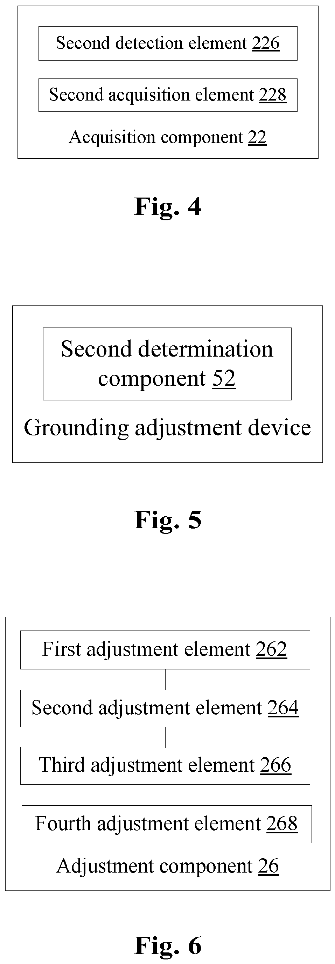

Fig. 4 is a structural block diagram of a device for grounding adjustment according to a second embodiment of the disclosure; as shown in Fig. 4, the acquisition component 22 further includes: a second detection element 226 to detect a grounding circuit of the port to be detected; and a second acquisition element 228 to acquire the grounding parameter according to a detection result.

Fig. 5 is a structural block diagram of a device for grounding adjustment according to a third embodiment of the disclosure; as shown in Fig. 5, the device further includes: a second determination component 52 to determine that the terminal has a port not meeting the preset requirement by detecting information about at least one of the following of the terminal: a signal strength of the terminal does not fall in a range of a first threshold, a signal frequency of the terminal does not fall in a range of a second threshold, a temperature of the terminal does not fall in a range of a third threshold.

Optionally, the first determination component 24 is further to determine the reason why the grounding state does not meet the preset requirement according to a position of the port to be detected in the terminal and a grounding mode of the port to be detected.

Fig. 6 is a structural block diagram of a device for grounding adjustment according to a fourth embodiment of the disclosure; as shown in Fig. 6, the adjustment component 26 includes: a first adjustment element 262 to adjust at least one of a grounding position and a grounding attribute of at least one of the port to be detected and a nearby port of the port to be detected; a second adjustment element 264 to adjust the grounding position of the port to be detected and increase the number of grounded ports on a shield circuit; a third adjustment element 266 to adjust a grounding mode of the port to be detected; and a fourth adjustment element 268 to adjust at least one of an antenna grounding feed point of the terminal and an antenna surrounding grounding circuit of the terminal.

Optionally, a grounding mode includes at least one of the following: analogue grounding, digital grounding, single point grounding, multipoint grounding, small-hole grounding, large-hole grounding, main reference grounding, non-main reference grounding.

Optionally, the grounding parameter includes at least one of the following: grounding resistance, grounding current, grounding voltage.

It should be noted that each above component may be realized through software or hardware; the latter one may be realized through, without limitation, the following ways: each above component is located in one same processor, or, each above component is located in a first processor, a second processor and a third processor... respectively.

In view of the above problem, description is provided below in conjunction with optional embodiments; the above optional embodiment and optional implementations thereof are combined in this embodiment.

This optional embodiment provides an intelligent safe stable high-performance mobile-terminal multi-mode grounding detection and calibration adjustment system, which adopts corresponding measures and modes to adjust grounding performances through the combination of a plurality of grounding modes built by hardware components, so as to guarantee the intelligent detection of grounding state of terminals.

This optional embodiment adopts the following technical scheme; the system of this optional embodiment includes: a multipoint grounding terminal, a grounding detection component, a grounding processing control component, a baseband chip, a grounding diagnosis component, an adaptive adjustment control component, a bad grounding adjustment component, a poor shielding adjustment component, a grounding mode switch component, an antenna grounding optimization component, a radio frequency chip component, a Liquid Crystal Display (LCD) display component, an antenna component, and a UI detection window.

The basic process of this optional embodiment is as follows:
When a user starts the grounding processing control component in the UI detection window, the mobile phone enters the grounding detection interface. The user activates each monitoring port randomly by clicking each grounding graphical window on the UI interface. The mobile phone makes the point-to-point grounding terminal of each monitoring port conducted to form a grounding detection circuit. The grounding detection circuit tests the current grounding circuit parameter and feeds back specific values to the baseband chip to convert into corresponding grounding parameters, and the grounding diagnosis component makes a specific diagnosis on a type of the grounding parameter and compares the grounding parameter with standard values and thresholds. If the grounding parameter exceeds a threshold, it is indicated that the port grounding is deteriorated, the adaptive adjustment control component is randomly started to self-calibrate this point, the adjustment component will make real-time adjustment according to the current grounding condition and tested value, and perform redetection until the deterioration is repaired. If the grounding state is too deteriorated to be directly repaired through software or hardware, or the current mode cannot be directly repaired, the UI window will display grounding state prompt information and suggestions, then the user or machine maintenance personnel may disassemble the machine for particular repair in view of the bad grounding point according to the prompt information. After the user starts the adaptive grounding adjustment control mode, the mobile phone will detect in real time the currently received signal strength and adjust the connection of the antenna and relevant circuit grounding terminals, so as to optimize the grounding connection mode towards the purpose of improving performance. When the mobile phone monitors that the current Signal Noise (SNR) or Ec or lo fluctuation is abnormal, the mobile phone will adjust the grounding mode of the grounding terminal of each shielding point so as to perform adjustment towards the purpose of improving the mobile phone shielding stability.

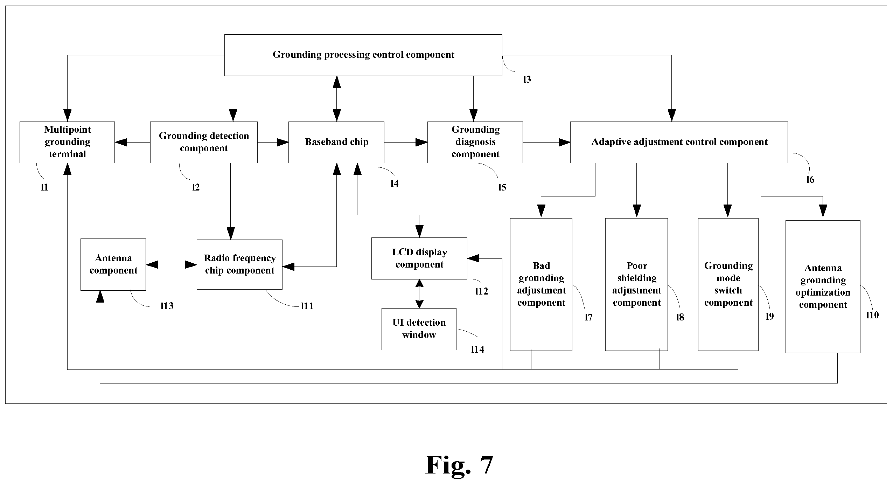

Fig. 7 is a diagram of a hardware structure realizing an intelligent grounding terminal according to the embodiment of the disclosure; as shown in Fig. 7, the mobile terminal includes a multipoint grounding terminal 11, a grounding detection component 12, a grounding processing control component 13, a baseband chip 14, a grounding diagnosis component 15, an adaptive adjustment control component 16, a bad grounding adjustment component 17, a poor shielding adjustment component 18, a grounding mode switch component 19, an antenna grounding optimization component 110, a radio frequency chip component 111, an LCD display component 112, an antenna component 113, and a UI detection window 114.

The multipoint grounding terminal 11 is connected with the grounding detection component 12, the grounding processing control component 13 and each grounding adjustment component 17-110 mentioned above, and is arranged to complete the collection of grounding parameter of each grounding point. The mobile phone is provided with multipoint grounding terminals on the circuit board, the antenna, and a key position between structural components; the terminal front end is arranged on two sides of a grounding material or grounding wire and reference site, the rear end is connected with a micro-switch in series, a single-ploe single-throw switch or single-ploe mutli-throw switch with low insertion loss may be selected correspondingly according to the number of contact points. The switch is connected to the baseband chip through a two-line Mobile Industry Processor Interface (MIPI) interface to be uniformly controlled. After the grounding processing control component is started, when a user clicks a terminal icon corresponding to a grounding point in the UI detection window on the LCD screen, the grounding detection component switches the corresponding grounding terminal to the conducting state, then, the grounding parameter and performance state of this point can be collected through the grounding detection component.

The grounding detection component 12 is connected with the multipoint grounding terminal 11, the grounding processing control component 13 and the baseband chip 14, and is arranged to complete the detection of each grounding parameter. The grounding detection component has direct and indirect detection modes. The grounding parameter may be grounding resistance, grounding current, grounding voltage.

The direct grounding detection mode obtains the grounding resistance value of a corresponding terminal by detecting the grounding parameter value of a single grounding circuit and transmitting the result to the baseband chip for further analysis and conversion processing. The grounding detection component is required to have high detection accuracy and small error, and meanwhile to have fine frequency response characteristic and be capable of simultaneously monitoring the grounding parameter in high, medium and low frequency bands of radio frequencies. The specific detection method is as follows: the grounding detection component first selects the nearest grounding circuit, the detection circuit first conducts self-calibration, adjusts the testing circuit to the zero potential state, and detects whether the reference main ground terminal meets a requirement, then makes the testing port connected and tests the current or voltage value at this time, then skips the testing terminal and adjusts, through a variable resistor, the current or voltage value to connect with the grounding terminal to be detected, at this time the adjusted final equivalent resistance is the grounding resistance to be detected. In the detection circuit, it is required to adjust the circuit internal resistance according to the stepping precision of test, meanwhile, the position of the reference grounding point also will be switched to collect the grounding resistance value, the final grounding resistance value is the average value of multiple circuits and multiple measurements, so as to prevent error detection and improve detection precision.

The indirect grounding detection mode obtains corresponding signal strength amplitude by collecting the current frequency point spurious signal of each radio frequency component and sending same to the mobile phone radio frequency chip to demodulate and to the baseband chip to process. This mode may collect in-band, out-band spurious signals of the mobile phone used frequency band, and frequency doubling and small-range harmonic signals. The mobile phone needs to switch to a broad band filter and a wave trap in this mode, to filter out the dominant frequency and reserve the to-be-detected signal. If an abnormal frequency point or excessive spurious signals are detected, the result may be send to the grounding diagnosis component for further processing. Meanwhile, the indirect grounding detection component also detects and reflects in real time a key parameter reflecting the current signal quality of the mobile phone, for example, Received Signal Strength Indication (RSSI), SNR, pilot signal SNR, Ec or Io and the like; by collecting the jumping law and frequency of these signals, and comparing with the stored sum of normal nominal values, the abnormal information is transmitted to the grounding diagnosis component for final judgment processing.

Finally, the indirect grounding detection component also is responsible for collecting the temperature parameter inside the mobile phone, the indirect grounding detection component is realized through a plurality of thermistors built in the high-heating area inside the mobile phone. The thermistor is arranged nearby the grounding point of the high-heating area, and the thermistor sends the collected parameter to the baseband chip for next processing, that is, converting into a specific heating temperature value, if the temperature is abnormal, exceeding a preset threshold, it is indicated that the grounding here is bad, and a grounding optimization adjustment is needed.

The grounding processing control component 13 is connected with the multipoint grounding terminal 11, the grounding detection component 12, the baseband chip 14, the grounding diagnosis component 15 and the adaptive adjustment control component 16, and is arranged to complete the enabling and disabling of the whole grounding detection, diagnosis and adaptive processing. The grounding processing control component first controls the baseband chip to switch between a detection mode and a normal working mode; the entire mobile phone may work in a single normal mode, also may work in a single detection mode, and also may work in the coexistence of the above two modes; the detection control component may be directly set by a user in a grounding detection interface box on the UI interface. Meanwhile, the grounding processing control component also is responsible for monitoring in real time the dynamic change of the currently collected grounding parameter of each grounding terminal and controls the adaptive adjustment control component to adopt corresponding adjustment measures.

The baseband chip 14 is connected with the grounding detection component 12, the grounding processing control component 13, the grounding diagnosis component 15, the radio frequency chip component 111 and the LCD display component 112, and is mainly responsible for the coordination control and calculation of each component and the digital processing of data collected by the grounding detection component, including: calculation of grounding parameter, statistics of RSSI, statistics of Receive Signal Code Power (RXCP), statistics of Ec or lo and SNR, etc., and sending the statistics and calculation result to the grounding diagnosis component to track in real time the working state of each current system parameter.

The grounding diagnosis component 15 is connected with the baseband chip 14, the grounding processing control component 13 and the adaptive adjustment control component 16, and is arranged to complete the detailed diagnosis analysis of grounding parameter of each terminal, including: estimation of grounding goodness, estimation of grounding shielding effect, estimation of grounding mode reasonability, estimation of influence of grounding to antenna performance, etc. The grounding diagnosis component first determines the position of the grounding terminal in the mobile phone according to the grounding data collected by the baseband chip, determines whether the grounding is the grounding between each part and structure component, for example, LCD, touch screen, magnesium aluminum alloy support plate, camera, Universal Serial Bus (USB), etc., or the grounding on the shielding rib, or the grounding of the power supply circuit and the decoupling circuit and the key radio frequency circuit in the circuit, or the grounding of the antenna feed point and clearance area, and sends the judgment result to the adaptive adjustment control component to perform corresponding grounding adjustment processing. Then, the grounding diagnosis component compares the tested grounding parameter with the nominal value at this position, and, if the grounding parameter exceeds the range of a threshold, outputs the diagnosis result, and, if the grounding resistance at certain position is required to be less than 0.5 Ohm, determines that the grounding exceeding this value is bad. The grounding diagnosis component also can determine the specific grounding type of the current grounding terminal, for example, analogue grounding, digital grounding, single point grounding, small-hole grounding, large-hole grounding, main reference grounding or non-main reference grounding, etc., and make a specific diagnosis result and a solution measure in conjunction with the grounding parameter and other mobile phone signal parameters.

The adaptive adjustment control component 16 is connected with the grounding diagnosis component 15 and each grounding adjustment component 17-110, and is mainly arranged to complete the adaptive adjustment control of each grounding component. If the adaptive adjustment control component has determined according to an output result of the grounding diagnosis component that bad grounding is caused by loose structure or poor assembly, the adaptive adjustment control component starts the bad grounding adjustment component to conduct adjustment; if bad grounding still exists after the user or assembly personnel performs rectification, a warning prompt is displayed on a corresponding window of the LCD, and the position node and specific grounding parameters are dynamically displayed; if bad shielding grounding has been determined, the poor shielding adjustment component is started to switch and change the grounding point or increase the number of grounding terminals, so that the grounding point can enhance the grounding strength in the surrounding of the shielding rib; if key circuit grounding has been determined, the grounding mode switch component is started to switch each grounding mode by monitoring each signal quality parameter of the mobile phone and performs dynamic optimization adjustment according to the reported value of the radio frequency and baseband chip; if the antenna relevant grounding terminal has been determined, the antenna grounding optimization component is started to adjust the grounding point position of the antenna feed point or multipoint grounding, and then performs adaptive feedback adjustment by monitoring performance relevant parameters of the current antenna.

The bad grounding adjustment component 17 is connected with the adaptive adjustment control component 16, the multipoint grounding terminal 11 and the LCD display component 112, and is mainly arranged to complete the optimization adjustment of bad grounding. When the bad grounding adjustment component 17 is started, the mobile phone first attempts performing adaptive switching adjustment for a nearby terminal of the bad grounding point to change the grounding position and attribute, and then tests whether a requirement is met; if the threshold requirement is not met, the adjustment mode will give other adjustment suggestions, for example, pressing this point, screw reinforcement or carrying to a maintenance agency to maintain, replacing or sticking conducting materials such as foam, conductive fabric, copper foil, etc.

The poor shielding adjustment component 18 is connected with the adaptive adjustment control component 16, the multipoint grounding terminal 11 and the LCD display component 112, and is mainly arranged to complete the adjustment for a grounding point with poor shielding. After the poor shielding adjustment component receives an adjustment instruction from the adaptive adjustment control component, the poor shielding adjustment component immediately controls each port switch to switch the grounding position and change the grounding point, and meanwhile to increase the number of conducting grounding terminals arranged on the shielding circuit so that the grounding point can enhance the grounding strength in the surrounding of the shielding circuit; the adjustment result is displayed on the UI detection window of the LCD.

The grounding mode switch component 19 is connected with the adaptive adjustment control component 16, the multipoint grounding terminal 11 and the LCD display component 112, and is arranged to complete the switch of grounding mode of each grounding terminal. There are many grounding modes in a mobile phone circuit system, for example, analogue grounding, digital grounding, single point grounding, multipoint grounding, small-hole grounding, large-hole grounding, main reference grounding, non-main reference grounding, etc., different grounding modes have great impact on both the board of the mobile phone and the radio frequency performance of the entire machine, and improper grounding modes often cannot be discovered at the beginning of board design, thereby key indexes of the mobile phone such as sensitivity and SNR are impacted; since mobile phones have big individual differences, the impact caused by grounding mode is different too; the grounding mode switch component can change the grounding mode to one mode more suitable for the performance of the mobile phone according to the real-time monitoring result of the adaptive adjustment control component, so that the whole call capability and interference rejection of the mobile phone can be extremely improved. The method for switching grounding modes is as follows: determining the original grounding mode according to the position where the corresponding circuit or grounding circuit is located, then adjusting the grounding return circuit loop size or changing the public impedance grounding point, changing the path of the original grounding return circuit link through each branch and switch arranged at the grounding point, that is, turning off or turning on, switching between single-point series connection grounding and single-point parallel connection grounding, or changing single point grounding to multipoint grounding, or changing multipoint grounding to single point grounding, or switching grounding wire grounding to big or small-hole direct grounding, etc. After the above grounding mode is switched, verify whether the calibration optimization adjustment is valid by monitoring the grounding detection component so as to perform a next adaptive control adjustment; the adjustment result is displayed on the UI detection window of the LCD.

The antenna grounding optimization component 110 is connected with the adaptive adjustment control component 16, the multipoint grounding terminal 11, the antenna component 113 and the LCD display component 112, and is arranged to complete the grounding optimization of each antenna performance. The antenna grounding optimization component mainly is divided into two parts: direct adjustment for an antenna grounding feed point and adjustment for an antenna surrounding grounding environment. For the former one, a plurality of grounding circuits is arranged on the mobile phone antenna circuit, and is adjusted to turn on or turn off flexibly through a switch; in actual debugging and user usage, further optimization adjustment may be performed in conjunction with the current antenna mode and needs. For the latter one, when the antenna surrounding grounding environment changes, the whole machine performance of the mobile phone will be reduced, the antenna grounding optimization component will detect the corresponding deteriorated position and turn on other assistant grounding circuits, so as to improve the whole grounding performance; the adjustment result is displayed on the UI detection window of the LCD.

The radio frequency chip component 111 is connected with the baseband chip 14, the antenna component 113 and the grounding detection component 12, and is mainly arranged to complete the modulation of each grounding related radio frequency signal. The radio frequency chip component feeds back the collected radio frequency signal to the baseband chip, then the baseband chip sends the detected grounding parameter and radio frequency parameter to the grounding diagnosis component for system analysis, so that a corresponding grounding adjustment measure is adopted.

The LCD display component 112 is connected with the baseband chip 14, the UI detection window and each grounding adjustment component 17-110, and is mainly arranged to complete the UI start of the grounding processing control component in cooperation with the signal quality detection in the baseband chip, display the grounding detection point in a distributed manner, display the detection result fed back by each grounding adjustment component and prompt calibration rectification measures.

The UI detection window 114 is connected with the LCD display component 112, and is arranged to start the grounding processing control component and activate each grounding terminal graphical window. When a user starts the grounding processing control component in the UI detection window, the mobile phone enters the grounding detection interface, the user activates each monitoring port randomly by clicking each grounding graphical window on the UI interface, the mobile phone makes the point-to-point grounding terminal of each monitoring port conducted to form a grounding detection circuit, the grounding detection circuit tests the current grounding circuit parameter and feeds back specific values to the baseband chip to convert into corresponding grounding parameters, and the tested value and other information are displayed on a corresponding sub-window of the UI.

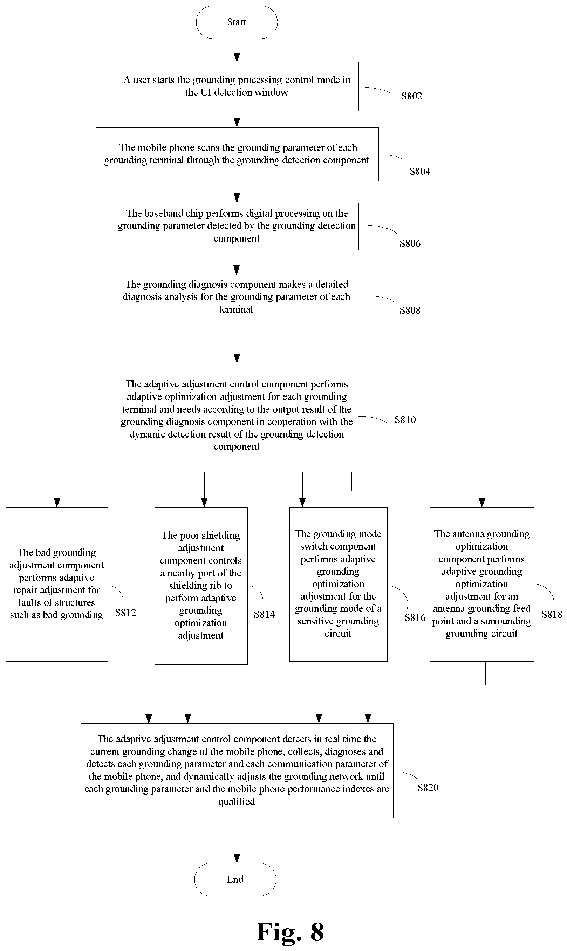

Fig. 8 is a specific working flowchart of an adaptive grounding adjustment terminal according to the embodiment of the disclosure, the process of a mobile terminal based on the above structure function performing multi-mode grounding detection and adaptive adjustment; the working flow based on adaptive grounding adjustment in this optional embodiment shown in Fig. 8 includes the following steps:
At step S802: After a user starts a grounding processing control mode, a mobile phone switches to a grounding detection mode. And then step S804 is executed.
At step S804: The mobile phone scans, through the grounding detection component, the grounding parameter of each grounding terminal and waits processing. And then step S806 is executed.
At step S806: The baseband chip performs digital processing on the grounding parameter detected by the grounding detection component, further collects spurious signal, gathers statistics of parameters such as RSSI, RXCP, Ec or lo, SNR and heating temperature, and sends the statistics and calculation result to the grounding diagnosis component. And then step S808 is executed.
At step S808: The grounding diagnosis component makes a detailed diagnosis analysis for the grounding parameter of each terminal and outputs the diagnosis result to the adaptive adjustment control component. And then step S810 is executed.
At step S810: The adaptive adjustment control component performs adaptive optimization adjustment for each grounding terminal and needs according to the output result of the grounding diagnosis component in cooperation with the dynamic detection result of the grounding detection component. If structure grounding is bad, step S812 is executed; if shielding grounding is bad, step S814 is executed; and, if key circuit grounding is bad, step S816 is executed; if antenna related grounding is bad, step S818 is executed.
At step S812: The bad grounding adjustment component first attempts performing adaptive switching adjustment for a nearby terminal of the bad grounding point to change the grounding position and attribute, and then tests whether a requirement is met; if the threshold requirement is not met, the adjustment mode will give other adjustment suggestions, and a warning prompt is displayed on a corresponding window of the LCD. And then, step S820 is executed.
At step S814: The poor shielding adjustment component controls a nearby port switch of the shielding rib to switch the grounding position and change the grounding point, and meanwhile to increase the number of conducting grounding terminals arranged on the shielding circuit so that the grounding point can enhance the grounding strength in the surrounding of the shielding circuit. And then, step S820 is executed.
At step S816: The grounding mode switch component changes the grounding mode of each port to one mode more suitable for the performance of the mobile phone according to the real-time monitoring result of the adaptive adjustment control component. And then, step S820 is executed.
At step S818: The antenna grounding optimization component directly adjusts the grounding mode of an antenna grounding feed point, meanwhile also can dynamically adjust an antenna surrounding grounding environment. And then, step S820 is executed.
At step S820: The adaptive adjustment control component detects in real time the current grounding change of the mobile phone, collects, diagnoses and detects each grounding parameter and each communication parameter of the mobile phone radio frequency, and dynamically adjusts the grounding network until each grounding parameter and the mobile phone performance indexes are qualified; the process is ended.

To sum up, the disclosure adopts an intelligent grounding monitoring system design, fully considers the interference and impact of each grounding mode, makes a reasonable improvement by using existing circuits and systems of current terminals, and is portable and lightweight; not comprehensive grounding detection can be conducted on each terminal before delivery, but also users also can perform real time intelligent detection on the grounding characteristic of each mobile phone according to actual signal quality and network condition, and mobile phone software can make real time analysis and processing on the tested grounding parameter change and perform adaptive grounding calibration so as to adjust each grounding state of the mobile phone in real time. The terminal user can enjoy high-performance call quality and data services stably and safely in any condition. Compared with existing technologies, the disclosure changes the situation that traditional grounding state is unchangeable, and realizes intelligent and safe grounding monitoring and dynamic adjustment using existing internal hardware and software of mobile phones. Meanwhile, the grounding processing and estimation are more scientific and reasonable; different solutions may be given for different abnormal grounding modes; while helping users, production testing personnel, professional maintenance personnel, research and development personnel to check mobile phone grounding performances, the disclosure also can make real-time optimization calibration and adjustment according to current signal strength, interference condition, shielding state and antenna performance state of mobile phones, so as to enhance user experiences and communication quality.

In another embodiment, a kind of software is provided to execute the technical scheme described in the above embodiments and example implementations.

In another embodiment, a storage medium is provided, which stores the above software; the storage medium includes but not limited to: compact disc, floppy disk, hard disk, erasable memory, etc.

Obviously, those skilled in the art should understand that the components or steps described above can be implemented by a common computer device; the components or steps can be integrated on a single computing device or distributed on a network composed of a plurality of computing devices; optionally, the components or steps can be implemented by a programming code executable by a computing device, thus they can be stored in a storage device to be executed by a computing device and executed in a different order in some cases, or manufactured into individual integrated circuit component respectively, or several of them can be manufactured into a single integrated circuit component to implement; in this way, the disclosure is not limited to any combination of specific hardware and software.

The above are only the example embodiments of the disclosure and not intended to limit the disclosure. For those skilled in the art, various modifications and changes can be made to the disclosure. Any modification, equivalent substitution and improvement made within the spirit and principle of the disclosure are intended to be included within the scope of protection of the disclosure.

### Industrial Applicability

As described above, the method and device for grounding adjustment provided by the embodiment of the disclosure have benefits as follows: compared with existing technologies, the disclosure changes the situation that traditional grounding state is unchangeable, and realizes intelligent and safe grounding monitoring and dynamic adjustment using existing internal hardware and software of mobile phones. Meanwhile, the grounding processing and estimation are more scientific and reasonable; different solutions may be given for different abnormal grounding modes; while helping users, production testing personnel, professional maintenance personnel, research and development personnel to check mobile phone grounding performances. The disclosure also can make real-time optimization calibration and adjustment according to current signal strength, interference condition, shielding state and antenna performance state of mobile phones, so as to enhance user experiences and communication quality.

## Claims

1. A method for grounding adjustment, comprising:
acquiring a grounding parameter of a port to be detected of a terminal, wherein the grounding parameter is reflective of a grounding state of the port to be detected;
when the grounding parameter exceeds a predetermined threshold, determining that the grounding state of the port to be detected does not meet a preset requirement; and
adjusting the port to be detected not meeting the preset requirement according to a reason why the grounding state does not meet the preset requirement.

2. The method as claimed in claim 1, wherein acquiring the grounding parameter of the port to be detected comprises:
receiving a detection instruction on a User Interface (UI); and
under a trigger of the detection instruction, acquiring the grounding parameter and displaying the grounding parameter on the UI.

3. The method as claimed in claim 1, wherein acquiring the grounding parameter of the port to be detected comprises:
detecting a grounding circuit of the port to be detected; and
acquiring the grounding parameter according to a detection result.

4. The method as claimed in claim 3, wherein before detecting the grounding circuit of the port to be detected, the method further comprises:
determining that the terminal has a port not meeting the preset requirement by detecting information about at least one of the following of the terminal:
a signal strength of the terminal does not fall in a range of a first threshold, a signal frequency of the terminal does not fall in a range of a second threshold, a temperature of the terminal does not fall in a range of a third threshold.

5. The method as claimed in claim 1, wherein the reason why the grounding state does not meet the preset requirement is determined by the following ways:
determining the reason why the grounding state does not meet the preset requirement according to a position of the port to be detected in the terminal and a grounding mode of the port to be detected.

6. The method as claimed in claim 1, wherein adjusting the port to be detected not meeting the preset requirement according to the reason why the grounding state does not meet the preset requirement comprises at least one of the following:
adjusting at least one of a grounding position and a grounding attribute of at least one of the port to be detected and a nearby port of the port to be detected;
adjusting a grounding position of the port to be detected and increasing a number of grounded ports on a shield circuit;
adjusting a grounding mode of the port to be detected; and
adjusting at least one of an antenna grounding feed point of the terminal and an antenna surrounding grounding circuit of the terminal.

7. The method as claimed in any one of claim 5 and claim 6, wherein
a grounding mode comprises at least one of the following: analogue grounding, digital grounding, single point grounding, multipoint grounding, small-hole grounding, large-hole grounding, main reference grounding, non-main reference grounding.

8. The method as claimed in any one of claims 1 to 6, wherein the grounding parameter comprises at least one of the following: grounding resistance, grounding current, grounding voltage.

9. A device for grounding adjustment, comprising:
an acquisition component to acquire a grounding parameter of a port to be detected of a terminal, wherein the grounding parameter is reflective of a grounding state of the port to be detected;
a first determination component to determine that the grounding state of the port to be detected does not meet a preset requirement in the case that the grounding parameter exceeds a predetermined threshold; and
an adjustment component to adjust the port to be detected not meeting the preset requirement according to a reason why the grounding state does not meet the preset requirement.

10. The device as claimed in claim 9, wherein the acquisition component comprises:
a first detection element to receive a detection instruction on a User Interface (UI); and
a first acquisition element to acquire the grounding parameter and display the grounding parameter on the UI under a trigger of the detection instruction.

11. The device as claimed in claim 9, wherein the acquisition component further comprises:
a second detection element to detect a grounding circuit of the port to be detected; and
a second acquisition element to acquire the grounding parameter according to a detection result.

12. The device as claimed in claim 11, wherein the device comprises:
a second determination component to determine that the terminal has a port not meeting the preset requirement by detecting information about at least one of the following of the terminal:
a signal strength of the terminal does not fall in a range of a first threshold, a signal frequency of the terminal does not fall in a range of a second threshold, a temperature of the terminal does not fall in a range of a third threshold.

13. The device as claimed in claim 9, wherein the first determination component is further to determine the reason why the grounding state does not meet the preset requirement according to a position of the port to be detected in the terminal and a grounding mode of the port to be detected.

14. The device as claimed in claim 9, wherein the adjustment component comprises at least one of the following:
a first adjustment element to adjust at least one of a grounding position and a grounding attribute of at least one of the port to be detected and a nearby port of the port to be detected;
a second adjustment element to adjust the grounding position of the port to be detected and increase the number of grounded ports on a shield circuit;
a third adjustment element to adjust a grounding mode of the port to be detected; and
a fourth adjustment element to adjust at least one of an antenna grounding feed point of the terminal and an antenna surrounding grounding circuit of the terminal.

15. The device as claimed in any one of claim 13 and claim 14, wherein
a grounding mode comprises at least one of the following: analogue grounding, digital grounding, single point grounding, multipoint grounding, small-hole grounding, large-hole grounding, main reference grounding, non-main reference grounding.

16. The device as claimed in any one of claims 9 to 14, wherein the grounding parameter comprises at least one of the following: grounding resistance, grounding current, grounding voltage.
